# EUROPEAN PATENT SPECIFICATION

(11) **EP 3 496 155 B1**
(45) Date of publication and mention of the grant of the patent: **15.01.2025**
(21) Application number: 18183096.9
(22) Date of filing: 12.07.2018
(51) Int. Cl.: H01L 31/0224, H01L 31/0236

(54) **SOLAR CELL**
SOLARZELLE
CELLULE SOLAIRE

(30) Priority: 08.12.2017 KR 20170168656
(43) Date of publication of application: 12.06.2019
(73) Proprietor: Changzhou Fusion New Material Co. Ltd., Jiangsu Province (CN)
(72) Inventor: PARK, Sang Hee, 16678 Suwon-si, Gyeonggi-do (KR); MOON, Sung Il, 16678 Suwon-si, Gyeonggi-do (KR); HA, Kyoung Jin, 16678 Suwon-si, Gyeonggi-do (KR)
(74) Representative: Michalski Hüttermann & Partner Patentanwälte mbB

(56) References cited:
- US-A1- 2011 139 236
- US-A1- 2015 291 811
- US-A1- 2016 240 703
- US-A1- 2017 294 545

## Description

### Field of the Invention

The present invention relates to a solar cell.

### Description of Related Art

Solar cells generate electricity using the photovoltaic effect of a PN junction which converts photons of sunlight into electricity. In a solar cell, front and rear electrodes are formed on upper and lower surfaces of a semiconductor wafer or substrate having a PN junction, respectively. Then, the photovoltaic effect at the PN junction is induced by sunlight entering the semiconductor wafer and electrons generated by the photovoltaic effect at the PN junction provide electric current to the outside through the electrodes. The electrodes of the solar cell are formed on the wafer by applying, patterning, and baking a composition for solar cell electrodes.

US 2011/139236 refers to a method for manufacturing a solar cell includes forming a textured surface at a surface of a substrate of a first conductivity type using a dry etching method, the textured surface having a plurality of jagged portions, forming a doping pattern by applying a doping material containing an impurity of a second conductivity type on a portion of the textured surface, forming an emitter region by doping the impurity of the second conductive type into the substrate to form a first emitter portion and a second emitter portion having a different impurity doped concentration from each other, forming an anti-reflection layer on the first emitter portion and the second emitter portion, and forming a first electrode connected to the second emitter portion and a second electrode connected to the substrate.

US 2015/291811 refers to a composition for solar cell electrodes and a solar cell electrode fabricated using the composition, the composition including a conductive powder; a glass frit; an organic vehicle; and a surface tension modifier, wherein the surface tension modifier has a surface tension of 40 mN/m to 65 mN/m, and the composition has a thixotropic index (TI) of 3 to 10. The thixotropic index is calculated using viscosity values of the composition measured at 10 rpm and 100 rpm and at 23° C. with a No. 14 Spindle using a rotary viscometer.

In order to reduce reflectance of light incident on a solar cell to improve efficiency of the solar cell, there has been proposed a method in which a surface of a substrate is textured and/or is formed with an anti-reflection film. However, this method cannot provide sufficient anti-reflection properties.

In addition, the method has a problem in that an electrode can have poor adhesion to the substrate having a textured surface.

Therefore, there is a need for a solar cell which can reduce reflection of light incident thereon and improve adhesion of an electrode to a substrate, thereby exhibiting good electrical properties, such as contact resistance, serial resistance, short-circuit current and conversion efficiency.

The background technique of the present invention is disclosed in Japanese Unexamined Patent Publication No. 2012-084585.

### Summary of the Invention

It is one aspect of the present invention to provide a composition for solar cell electrodes and a silicon substrate, which can reduce reflectance, thereby exhibiting improved conversion efficiency.

It is another aspect of the present invention to provide composition for solar cell electrodes and a silicon substrate which can improve adhesion of an electrode to a substrate, thereby exhibiting good electrical properties, such as contact resistance, serial resistance and short-circuit current.

These and other objects of the present invention can be achieved by embodiments of the present invention described below.

An aspect of the present invention relates in accordance with claim 1 to a silicon substrate of a solar cell, the silicon substrate comprising a composition for solar cell electrodes, wherein the silicon substrate is formed with at least 5 raised portions having a cross-sectional height (h) of 50 nm or more per 5 µm length, wherein the composition is applied on the silicon substrate to form the electrode and is deposited on the silicon substrate area formed with the raised portions, characterized in that the composition has a water contact angle of 15° to 60°,and wherein the water contact angle of the composition is measured by dropping distilled water on the surface of a film of the composition and measuring an angle between the tangent of the water and surface of the film at their junction.

The composition for solar cell electrodes may include: 60 wt% to 95 wt% of a conductive powder; 0.1 wt% to 20 wt% of a glass frit; 0.1 wt% to 15 wt% of an organic binder; 0.1 wt% to 5 wt% of a surface tension modifier; and 0.1 wt% to 20 wt% of a solvent.

The glass frit may include at least one elemental metal oftellurium (Te), lithium (Li), zinc (Zn), bismuth (Bi), lead (Pb), sodium (Na), phosphorus (P), germanium (Ge), gallium (Ga), cerium (Ce), iron (Fe), silicon (Si), tungsten (W), magnesium (Mg), molybdenum (Mo), cesium (Cs), strontium (Sr), titanium (Ti), tin (Sn), indium (In), vanadium (V), barium (Ba), nickel (Ni), copper (Cu), potassium (K), arsenic (As), cobalt (Co), zirconium (Zr), manganese (Mn), aluminum (Al), and boron (B).

The surface tension modifier may include at least one of a silicone-based additive, an amide-based additive, and a fatty acid-based surfactant.

The solvent may include at least one of hexane, toluene, ethyl cellosolve, cyclohexanone, butyl cellosolve, butyl carbitol (diethylene glycol monobutyl ether), dibutyl carbitol (diethylene glycol dibutyl ether), butyl carbitol acetate (diethylene glycol monobutyl ether acetate), propylene glycol monomethyl ether, hexylene glycol, methylethylketone, benzylalcohol, γ-butyrolactone, ethyl lactate, texanol, and diethylene glycol dibutyl ether.

The organic binder may include at least one of ethyl hydroxyethyl cellulose, nitrocellulose, blends of ethyl cellulose and phenol resins, alkyd resins, phenol resins, acrylate ester resins, xylene resins, polybutane resins, polyester resins, urea resins, melamine resins, vinyl acetate resins, wood rosin, polymethacrylates of alcohols, polyvinyl butyrate, and polyvinyl acetal.

The composition for solar cell electrodes may further include at least one additive of a dispersant, a thixotropic agent, a plasticizer, a viscosity stabilizer, an anti-foaming agent, a pigment, a UV stabilizer, an antioxidant, and a coupling agent.

The present invention provides a solar cell which can reduce reflectance, thereby exhibiting improved conversion efficiency and can improve adhesion of an electrode to a substrate, thereby exhibiting good electrical properties, such as contact resistance, serial resistance and short-circuit current.

### Brief Description of Drawings

FIG. 1 is a schematic view of a solar cell according to one embodiment of the present invention.
Fig. 2 is a view illustrating the definition of a raised portion according to the present invention.
FIG. 3 is an electron microscope image showing a raised portion of a solar cell according to the present invention.
FIG. 4 is a view illustrating the measurement of a water contact angle of a composition.

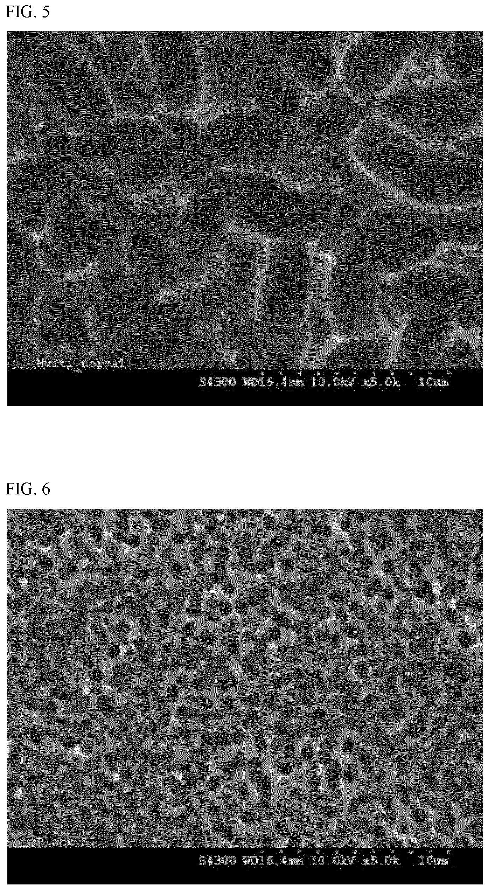

FIG. 5 is an electron microscope image of Comparative Example 3 (a surface of a typical substrate).
FIG. 6 is an electron microscope image of a surface of a substrate according to Example of the present invention.

### Detailed Description of the Invention

Hereinafter, embodiments of the present invention will be described in detail.

Description of known functions and constructions which may unnecessarily obscure the subject matter of the present invention will be omitted.

As used herein, the singular forms, "a," "an," and "the" are intended to include the plural forms as well, unless context clearly indicates otherwise. Moreover, the terms "includes," "including," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof.

In addition, unless stated otherwise, a margin of error is considered in analysis of components.

As used herein, the term "metal oxide" may refer to one metal oxide or a plurality of metal oxides.

Further, "X to Y", as used herein to represent a range of a certain value, means "greater than or equal to X and less than or equal to Y".

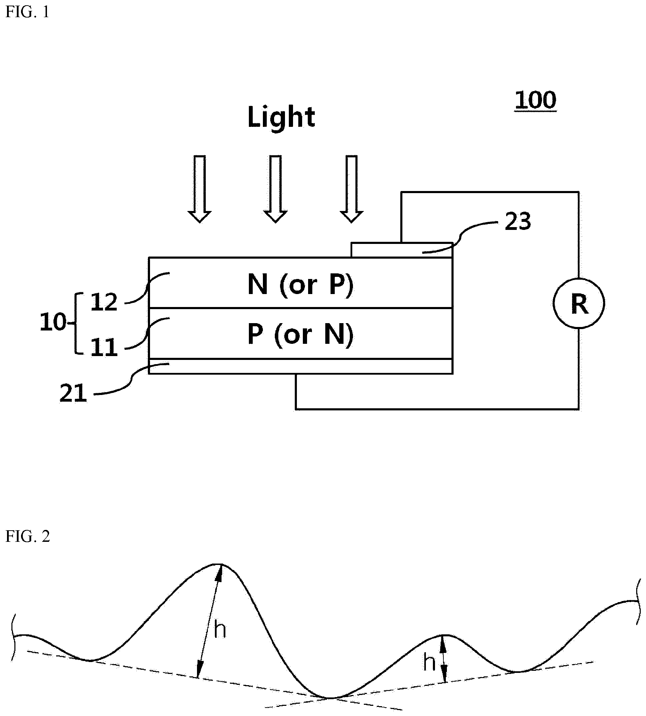

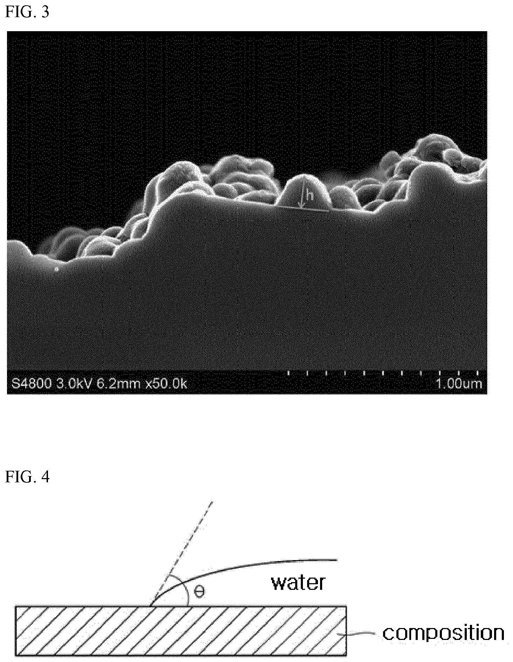

As used herein, the phrase "a substrate has a raised portion having a height (h) of 50 nm or more" means that the portion is higher than the surrounding surface and has a diameter of 500 nm or less, and a vertical distance from the summit of the portion to a line connecting both sides of the portion is 50 nm or more in sectional view of the silicon substrate (see FIG. 2). FIG. 3 is an actual sectional image of a silicon substrate for defining a raised portion according to the present invention.

### Solar cell

A solar cell according to one embodiment of the present invention will be described with reference to FIG. 1. FIG. 1 is a schematic view of a solar cell according to one embodiment of the present invention.

The solar cell 100 according to this embodiment may include a silicon substrate 10 and an electrode formed on the silicon substrate 10. Specifically, the solar cell may include a front electrode 23 formed on a front surface of the silicon substrate 10. The silicon substrate 10 may be a substrate with a PN junction formed thereon, and a rear electrode 21 may be formed on a back surface of the silicon substrate 10. Specifically, the silicon substrate 10 may include a semiconductor substrate 11 and an emitter 12. More specifically, the silicon substrate 10 may be a substrate prepared by doping one surface of a p-type semiconductor substrate 11 with an n-type dopant to form an n-type emitter 12. Alternatively, the substrate 10 may be a substrate prepared by doping one surface of an n-type semiconductor substrate 11 with a p-type dopant to form a p-type emitter 12. Here, the semiconductor substrate 11 may be either a p-type substrate or an n-type substrate. The p-type substrate may be a semiconductor substrate 11 doped with a p-type dopant, and the n-type substrate may be a semiconductor substrate 11 doped with an n-type dopant.

In description of the silicon substrate 10, the semiconductor substrate 11 and the like, a surface of such a substrate through which light enters the substrate is referred to as a front surface (light receiving surface). In addition, a surface of the substrate opposite the front surface is referred to as a back surface.

In one embodiment, the semiconductor substrate 11 may be formed of crystalline silicon or a compound semiconductor. Here, the crystalline silicon may be monocrystalline or polycrystalline. As the crystalline silicon, for example, a silicon wafer may be used.

Here, the p-type dopant may be a material including a group III element such as boron, aluminum, or gallium. In addition, the n-type dopant may be a material including a group V element, such as phosphorus, arsenic or antimony.

The rear electrode 21 and/or the front electrode 23 may be fabricated using a composition for solar cell electrodes described below. Specifically, the rear electrode and/or the front electrode may be fabricated through a process in which the composition for solar cell electrodes is deposited on the substrate by printing, followed by baking.

The solar cell 100 according to this embodiment includes the silicon substrate 10 and the electrode formed on the substrate 10, wherein the silicon substrate may be formed with 5 or more, specifically 5 to 100, more specifically 5 to 50 raised portions having a height (h) of 50 nm or more per 5 µm length in sectional view.

The silicon substrate having 5 or more raised portions can have higher surface roughness than a typical Si wafer, thereby further reducing reflectance of sunlight and can have an increased contact area with the electrode, thereby providing good properties in terms of contact resistance (Rc) and short-circuit current (Isc).

There are two primary methods to form a nano-texture (or raised portions) on the silicon substrate: wet etching and dry etching. A representative example of wet etching is metal catalyzed chemical etching (MCCE). For example, saw damage caused by diamond sawing is removed through a saw damage removal (SDR) process, followed by formation of a nano-texture through MCCE. Herein, "MCCE" refers to a process of gradually etching a surface of a Si substrate with silver nitrate (AgNO₃), followed by removal of silver nanoparticles, i.e., byproducts. A representative example of dry etching is reactive ion etching (RIE) in which a silicon wafer subjected to SDR is dry-etched using plasma. Here, SF₆/O₂ gas is used to generate plasma and a SiOF layer used as a mask needs to be removed.

In the present invention, a nano-texture (or the number of raised portions) of the silicon substrate is controlled by wet etching.

In another embodiment, the solar cell according of the present invention may further include an anti-reflection film (not shown) on the front surface of the silicon substrate 10. In addition, a back surface field layer (not shown), an anti-reflection film(not shown), and the rear electrode 21 may be sequentially formed on the back surface of the silicon substrate 10. Here, the front electrode 23 or the rear electrode 21 may be formed in a bus bar pattern.

Hereinafter, for convenience of explanation, each component of the solar cell according to the present invention will be described on the assumption that the semiconductor substrate 11 is a p-type substrate. However, it should be understood that the present invention is not limited thereto and the semiconductor substrate 11 may be an n-type substrate.

One surface of the p-type substrate 11 is doped with an n-type dopant to form an n-type emitter 12 to establish a PN junction. Here, the PN junction may be established at an interface between the semiconductor substrate and the emitter. Electrons generated in the PN junction may be collected by the front electrode 23.

The substrate 10 may have a textured structure on the front surface thereof. The textured structure may be formed by surface treatment of the front surface of the substrate 10 using a typical method known in the art, such as etching. The textured structure serves to condense light entering the front surface of the substrate. The textured structure may have a pyramidal shape, a square honeycomb shape, a triangular honeycomb shape, and the like. Thus, the textured structure allows an increased amount of light to reach the PN junction and reduces reflectance of light, thereby minimizing optical loss.

According to the present invention, the silicon substrate having the textured structure may further be formed with raised portions, thereby further reducing reflectance of sunlight while providing further improved properties in terms of contact resistance (Rc) and short-circuit current (Isc).

The p-type substrate may be formed on the back surface thereof with the back surface field (BSF) layer capable of inducing back surface field (BSF) effects.

The back surface field layer is formed by doping the back surface of the p-type semiconductor substrate 11 with a high concentration of p-type dopant. The back surface field layer has a higher doping concentration than the p-type semiconductor substrate 11, which results in a potential difference between the back surface field layer and the p-type semiconductor substrate 11. This makes it difficult for electrons generated in the p-type semiconductor substrate 11 to shift towards the back surface of the substrate so as to prevent recombination with metals, thereby reducing electron loss. As a result, both open circuit voltage (Voc) and fill factor can be increased, thereby improving solar cell efficiency.

In addition, a first anti-reflection film (not shown) and/or a second anti-reflection film may be formed on an upper surface of the n-type emitter 12 and on a lower surface of the back surface field layer, respectively.

The first and second anti-reflection films can reduce reflectance of light while increasing absorption of light at a specific wavelength. In addition, the first and second anti-reflection films can enhance contact efficiency with silicon present on the surface of the silicon substrate 10, thereby improving solar cell efficiency. Accordingly, the first and second anti-reflection films may include a material that reflects less light and exhibits electric insulation. Further, the first and second anti-reflection films may have an uneven surface, or may have the same form as that of the textured structure formed on the substrate. In this case, return loss of incident light can be reduced.

The first and second anti-reflection films may include at least one of, for example, oxides including aluminum oxide (Al₂O₃), silicon oxide (SiO₂), titanium oxide (TiO₂ or TiO₄), magnesium oxide (MgO), cerium oxide (CeO₂), or combinations thereof; nitrides including aluminum nitride (AlN), silicon nitride (SiNx), titanium nitride (TiN), or combinations thereof; and oxynitrides including aluminum oxynitride (AlON), silicon oxynitride (SiON), titanium oxynitride (TiON), or combinations thereof. In this case, the first and second anti-reflection films can exhibit further improved anti-reflection efficiency.

The anti-reflection films may be formed by, for example, atomic layer deposition (ALD), vacuum deposition, atmospheric pressure chemical vapor deposition, plasma enhanced chemical vapor deposition, and the like.

In one embodiment, the anti-reflection films may be formed of silicon nitride (SiNₓ) or the like by plasma enhanced chemical vapor deposition (PECVD). By way of another example, the anti-reflection films may be formed of aluminum oxide (Al₂O₃) or the like by atomic layer deposition (ALD).

In one embodiment, the first anti-reflection film may be formed on the front surface of the silicon substrate 10 and may have a monolayer or multilayer structure.

When the back surface of the p-type semiconductor substrate 11 is doped with boron to form the back surface field layer, the second anti-reflection film may be formed on a lower surface of the back surface field layer. The second anti-reflection film can further increase open circuit voltage.

After formation of the anti-reflection films, the front electrode 23 electrically connected to the n-type emitter layer 12 and the rear electrode 21 electrically connected to the p-type substrate 11 may be formed. The front electrode 23 allows electrons collected by the n-type emitter to shift thereto. The rear electrode 21 electrically communicates with the p-type substrate and serves as a path through which electric current flows.

In this embodiment, the front electrode 23 and the rear electrode 21 may be formed of the composition for solar cell electrodes.

For example, the composition for solar cell electrodes may be deposited on the back surface of the PN junction substrate by printing. Then, a preliminary process of preparing the rear electrode is performed by drying at 200°C to 400°C for 10 to 60 seconds. Further, a preliminary process for preparing the front electrode may be performed by printing the composition for solar cell electrodes on the front surface of the PN junction substrate, followed by drying the printed composition. Then, the front electrode and the rear electrode may be formed by baking at 400°C to 950°C, for example, at 750°C to 950°C, for 30 to 210 seconds or 30 to 180 seconds.

When the front electrode or the rear electrode according to this embodiment of the present invention is formed of the composition for solar cell electrodes described below, the silicon substrate can exhibit good adhesion to the electrodes despite having the raised portions, thereby providing further improved properties in terms of contact resistance, serial resistance and the like.

### Composition for solar cell electrodes

The composition for solar cell electrodes according to the present invention may include a conductive powder, a glass frit, an organic binder, a surface tension modifier, and a solvent.

Now, each component of the composition for solar cell electrodes according to the present invention will be described in more detail.

### Conductive powder

The composition for solar cell electrodes according to the present invention may include silver (Ag) powder as the conductive powder. The silver powder may have a nanometer or micrometer-scale particle size. For example, the silver powder may have an average particle diameter of dozens to several hundred nanometers, or an average particle diameter of several to dozens of micrometers. Alternatively, the silver powder may be a mixture of two or more types of silver powder having different particle sizes.

The silver powder may have, for example, a spherical, flake or amorphous particle shape.

The average particle diameter may be measured using, for example, a Model 1064D (CELAS Co., Ltd.) after dispersing the conductive powder in isopropyl alcohol (IPA) at 25°C for 3 minutes via ultrasonication. The conductive powder may be present in an amount of 60 wt% to 95 wt% based on the total weight of the composition for solar cell electrodes. Within this range, the composition can reduce resistance of a solar cell electrode, thereby improving conversion efficiency of a solar cell. In addition, the composition can be easily prepared in paste form. Specifically, the silver powder may be present in an amount of 60 wt% to 95 wt% based on the total weight of the composition for solar cell electrodes. Within this range, the composition can improve conversion efficiency of a solar cell and can be easily prepared in paste form.

### Glass frit

The glass frit serves to form silver crystal grains in an emitter region by etching an anti-reflection layer and melting the conductive powder during a baking process of the composition for solar cell electrodes. Further, the glass frit improves adhesion of the conductive powder to a wafer and is softened to decrease the baking temperature during the baking process.

The glass frit may include at least one elemental metal of tellurium (Te), lithium (Li), zinc (Zn), bismuth (Bi), lead (Pb), sodium (Na), phosphorus (P), germanium (Ge), gallium (Ga), cerium (Ce), iron (Fe), silicon (Si), tungsten (W), magnesium (Mg), molybdenum (Mo), cesium (Cs), strontium (Sr), titanium (Ti), tin (Sn), indium (In), vanadium (V), barium (Ba), nickel (Ni), copper (Cu), potassium (K), arsenic (As), cobalt (Co), zirconium (Zr), manganese (Mn), aluminum (Al), and boron (B). The glass frit may be formed of an oxide of the at least one elemental metal.

For example, the glass frit may include at least one of Bi-Te-O glass frits, Pb-Bi-O glass frits, Pb-Te-O glass frits, Te-B-O glass frits, Te-Ag-O glass frits, Pb-Si-O glass frits, Bi-Si-O glass frits, Te-Zn-O glass frits, Bi-B-O glass frits, Pb-B-O glass frits, Bi-Mo-O glass frits, Mo-B-O glass frits, and Te-Si-O glass frits. In this case, a solar cell electrode formed of the composition can exhibit good balance between electrical properties.

The glass frit may be prepared by any suitable method known in the art. For example, the glass frit may be prepared by mixing the aforementioned components using a ball mill or a planetary mill, melting the mixture at 900°C to 1300°C, and quenching the melted mixture to 25°C, followed by pulverizing the obtained product using a disk mill, a planetary mill or the like. The glass frit may have an average particle diameter (D50) of 0.1 µm to 10 µm.

The glass frit may be present in an amount of 0.1 wt% to 20 wt%, specifically 0.5 wt% to 10 wt% based on the total weight of the composition for solar cell electrodes. Within this range, the glass frit can secure stability of a PN junction under various sheet resistances, minimize resistance, and ultimately improve the efficiency of a solar cell.

### Organic binder

The organic binder resin may be selected from acrylate resins or cellulose resins. Ethyl cellulose is generally used as the organic binder. In addition, the organic binder may include at least one of ethyl hydroxyethyl cellulose, nitrocellulose, blends of ethyl cellulose and phenol resins, alkyd resins, phenol resins, acrylate ester resins, xylene resins, polybutane resins, polyester resins, urea resins, melamine resins, vinyl acetate resins, wood rosin, polymethacrylates of alcohols, polyvinyl butyrate, and polyvinyl acetal.

The organic binder may be present in an amount of 0.1 wt% to 15 wt%, specifically 0.1 wt% to 10 wt% in the composition for solar cell electrodes. Within this range, the organic binder can provide sufficient adhesive strength to a solar cell electrode formed of the composition.

### Surface tension modifier

The surface tension modifier serves to control a water contact angle of the composition for solar cell electrodes.

The surface tension modifier may include at least one of a silicone-based additive, an amide-based additive, and a fatty acid-based surfactant. Here, the kind and amount of the surface tension modifier may be adjusted depending on the kinds and amounts of the other components so as to obtain a desired water contact angle of the composition.

The surface tension modifier may be present in an amount of 0.1 wt% to 5 wt%, specifically 0.1 wt% to 4 wt% in the composition for solar cell electrodes. Within this range, the water contact angle of the composition for solar cell electrodes can be easily controlled.

### Solvent

The solvent may include at least one selected from the group consisting of, for example, hexane, toluene, ethyl cellosolve, cyclohexanone, butyl cellosolve, butyl carbitol (diethylene glycol monobutyl ether), dibutyl carbitol (diethylene glycol dibutyl ether), butyl carbitol acetate (diethylene glycol monobutyl ether acetate), propylene glycol monomethyl ether, hexylene glycol, methylethylketone, benzyl alcohol, γ-butyrolactone, ethyl lactate, texanol, and diethylene glycol dibutyl ether. Here, the amount of the solvent may be adjusted depending on the other components so as to obtain a desired water contact angle of the composition. Particularly, the water contact angle of the composition for solar cell electrodes according to the present invention can be easily controlled using a proper combination of the surface tension modifier and the solvent.

The solvent may be present in an amount of 0.1 wt% to 20 wt%, specifically, 0.1 wt% to 15 wt% in the composition for solar cell electrodes. Within this range, the water contact angle of the composition solar cell electrodes can be easily controlled.

### Additive

The composition for solar cell electrodes according to the present invention may further include any typical additive to enhance flowability, processability and stability, as needed. The additive may include a dispersant, a thixotropic agent, a plasticizer, a viscosity stabilizer, an anti-foaming agent, a pigment, a UV stabilizer, an antioxidant, a coupling agent, and the like. These may be used alone or as a mixture thereof. The additive may be present in an amount of 0.1 wt% to 5 wt% based on the total weight of the composition for solar cell electrodes, although the content of the additive may be changed, as needed.

The composition for solar cell electrodes according to the present invention may have a water contact angle of 15° to 60°. Within this range, the composition can be well deposited on the silicon substrate formed with the raised portions and can have good adhesion to the substrate, thereby further improving electrical properties such as contact resistance and serial resistance.

Next, the present invention will be described in more detail with reference to examples. However, it should be noted that these examples are provided for illustration only and should not be construed in any way as limiting the invention.

In addition, description of details apparent to those skilled in the art will be omitted for clarity.

### Example 1

As an organic binder, 2.0 wt% of ethylcellulose (STD4, Dow Chemical Company) was sufficiently dissolved in 4.2 wt% of 2,2,4-trimethyl-1,3-pentanediol monoisobutyrate (Texanol, Eastman Chemicals) at 60°C, and then 88.9 wt% of spherical silver powder (AG-4-8, Dowa Hightech Co., Ltd.) having an average particle diameter of 2.0 µm, 3.1 wt% of a Pb-Te-O glass frit having an average particle diameter of 1.0 µm (Tg: 275°C, Tc: 410°C, Tm: 530°C), 0.5 wt% of a surface tension modifier (KF-96, Shinetsu Chemical Co., Ltd.), 0.5 wt% of a dispersant (BYK102, BYK-chemie), and 0.8 wt% of a thixotropic agent (Thixatrol ST, Elementis Co., Ltd.) were added to the binder solution, followed by mixing and kneading in a 3-roll kneader, thereby preparing a composition for solar cell electrodes. The composition had a water contact angle of 43.5°.

The composition was deposited onto a front surface of a silicon substrate by screen printing in a predetermined pattern, followed by drying in an IR drying furnace. A cell formed according to this procedure was subjected to baking at 600°C to 900°C for 30 to 210 seconds in a belt-type baking furnace, thereby fabricating a solar cell.

### Example 2

A solar cell was fabricated in the same manner as in Example 1 except that butyl carbitol acetate (BCA, Dow Chemical Company) was used as a solvent instead of Texanol, such that the composition for solar cell electrodes had a water contact angle of 21.2°.

### Example 3

A solar cell was fabricated in the same manner as in Example 1 except that spherical silver powder (AG-4-100, Dowa Hightech Co., Ltd.) having an average particle diameter of 2.0 µm was used instead of the silver powder (AG-4-8, Dowa Hightech Co., Ltd.), such that the composition for solar cell electrodes had a water contact angle of 57.1°.

### Example 4

A solar cell was fabricated in the same manner as in Example 1 except that 3.1 wt% of a Bi-Te-O glass frit having an average particle diameter of 1.0 µm (Tg: 296°C, Tc: 419°C, Tm: 611°C) was used instead of the Pb-Te-O glass frit, 0.5 wt% of oleic acid was further used as a surface tension modifier, and 0.3 wt% of the dispersant (BYK102, BYK-chemie) and 0.5 wt% of the thixotropic agent (Thixatrol ST, Elementis Co., Ltd.) were used, such that the composition for solar cell electrodes had a water contact angle of 49.2°.

### Example 5

A solar cell was fabricated in the same manner as in Example 1 except that a silicon substrate formed with 5 raised portions was used.

### Comparative Example 1

A solar cell was fabricated in the same manner as in Example 1 except that terpineol (Sigma-Aldrich Co., Ltd.) was used as a solvent instead of Texanol, such that the composition for solar cell electrodes had a water contact angle of 12.6°.

### Comparative Example 2

A solar cell was fabricated in the same manner as in Example 1 except that 3.1 wt% of a Bi-Te-O glass frit having an average particle diameter of 1.0 µm (Tg: 296°C, Tc: 419°C, Tm: 611°C) was used instead of the Pb-Te-O glass frit, and 3.2 wt% of Texanol, 2.0 wt% of the surface tension modifier (KF-96, Shinetsu Chemical Co., Ltd.), 0.3 wt% of the dispersant (BYK102, BYK-chemie), and 0.5 wt% of the thixotropic agent (Thixatrol ST, Elementis Co., Ltd.) were used, such that the composition for solar cell electrodes had a water contact angle of 67.2°.

### Comparative Example 3

A solar cell was fabricated in the same manner as in Example 1 except that a silicon substrate formed with 2 raised portions was used.

### Comparative Example 4

A solar cell was fabricated in the same manner as in Example 1 except that a silicon substrate without any raised portion (the number of raised portions: 0) was used.

### Property evaluation

(1) Number of raised portions: The number of raised portions having a height (h) of 50 nm or more per 5 µm length was measured ten times using an electron microscope image of the cross-section of each of the solar cells fabricated in Examples and Comparative Examples, followed by averaging the values. Results are shown in Table 1.
(2) Water contact angle (°): Water contact angle of each of the compositions for solar cell electrodes prepared in Examples and Comparative Examples was measured through a process in which the composition for solar cell electrodes was applied to a polymer film at room temperature (20°C to 25°C) using a squeegee to form a film and then distilled water was dropped onto a surface of the film using a micro syringe, followed by measurement of an angle between the tangent of the liquid at a liquid-solid-gas junction and the surface of the film using a contact angle meter (Phoenix 300 plus, SEO Co., Ltd.). Here, the polymer film may be a polyethylene terephthalate (PET) film, without being limited thereto.
(3) Short-circuit current (Isc, A), serial resistance (Rs, mS2), fill factor (%) and efficiency (%): Each of the compositions for solar cell electrodes prepared in Examples and Comparative Examples was deposited onto a front surface of a wafer by screen printing in a predetermined pattern, followed by drying in an IR drying furnace. Then, an aluminum paste was printed onto a back surface of the wafer and dried in the same manner as above. A cell formed according to this procedure was subjected to drying and baking at 200°C to 900°C for 30 to 180 seconds in a belt-type baking furnace, and then evaluated as to short-circuit current (Isc, A), serial resistance (Rs, S2), fill factor (FF, %) and conversion efficiency (Eff., %) using a solar cell efficiency tester CT-801 (Pasan Co., Ltd.). Results are shown in Table 1.

**Table 1**

| | Number of raised portions | Water contact angle (°) | Short-circuit current (A) | Serial resistance (Ω) | FF (%) | Eff. (%) |
|---|---|---|---|---|---|---|
| Example 1 | 12 | 43.5 | 8.804 | 0.00224 | 79.826 | 18.356 |
| Example 2 | 9 | 21.2 | 8.783 | 0.00218 | 79.923 | 18.344 |
| Example 3 | 18 | 57.1 | 8.830 | 0.00240 | 79.580 | 18.360 |
| Example 4 | 17 | 49.2 | 8.808 | 0.00225 | 79.789 | 18.387 |
| Example 5 | 5 | 43.5 | 8.820 | 0.00229 | 79.637 | 18.344 |
| Comparative Example 1 | 8 | 12.6 | 8.701 | 0.00287 | 78.570 | 17.968 |
| Comparative Example 2 | 11 | 67.2 | 8.772 | 0.00312 | 77.629 | 18.061 |
| Comparative Example 3 | 2 | 43.5 | 8.717 | 0.00276 | 78.621 | 17.959 |
| Comparative Example 4 | 0 | 43.5 | 8.366 | 0.00716 | 71.526 | 16.087 |

As shown in Table 1, it can be seen that the solar cells of Examples 1 to 5 in which the number of raised portions and the water contact angle of the composition fell within the ranges set forth herein had high short-circuit current and low serial resistance (Rs) and thus high fill factor (FF) and conversion efficiency.

Conversely, the solar cell of Comparative Example 1 exhibited low short-circuit current due to low water contact angle (15° or less) and had high serial resistance (Rs), and the solar cell of Comparative Example 2 had sufficiently high short-circuit current due to high water contact angle (60° or more), but exhibited poor pattern printability and thus high serial resistance (Rs) and low conversion efficiency. In addition, the solar cells of Comparative Examples 3 to 4 in which the number of raised portions of the silicon substrate was less than the range set forth herein had low short-circuit current and high serial resistance (Rs).

Although some embodiments have been described herein, it should be understood that these embodiments are provided for illustration only. The scope of the present invention should be defined by the appended claims.

### <List of Reference Numerals>

- 10:: substrate
- 11:: semiconductor substrate
- 12:: emitter
- 21:: rear electrode
- 23:: front electrode

## Claims

1. A silicon substrate of a solar cell, the silicon substrate comprising a composition for solar cell electrodes, wherein the silicon substrate is formed with at least 5 raised portions having a cross-sectional height (h) of 50 nm or more per 5 µm length, wherein the composition is applied on the silicon substrate to form the electrode and is deposited on the silicon substrate area formed with the raised portions, **characterized in that** the composition has a water contact angle of 15° to 60°,and wherein the water contact angle of the composition is measured by dropping distilled water on the surface of a film of the composition and measuring an angle between the tangent of the water and surface of the film at their junction.

2. A silicon substrate of a solar cell according to claim 1, wherein the composition for solar cell electrodes includes: 60 wt% to 95 wt% of a conductive powder; 0.1 wt% to 20 wt% of a glass frit; 0.1 wt% to 15 wt% of an organic binder; 0.1 wt% to 5 wt% of a surface tension modifier; and 0.1 wt% to 20 wt% of a solvent.

3. A silicon substrate of a solar cell according to claim 2, wherein the glass frit includes at least one elemental mental of tellurium (Te), lithium (Li), zinc (Zn), bismuth (Bi), lead (Pb), sodium (Na), phosphorus (P), germanium (Ge), gallium (Ga), cerium (Ce), iron (Fe), silicon (Si), tungsten (W), magnesium (Mg), molybdenum (Mo), cesium (Cs), strontium (Sr), titanium (Ti), tin (Sn), indium (In), vanadium (V), barium (Ba), nickel (Ni), copper (Cu), potassium (K), arsenic (As), cobalt (Co), zirconium (Zr), manganese (Mn), aluminum (Al), and boron (B).

4. A silicon substrate of a solar cell according to claims 2 or 3, wherein the surface tension modifier includes at least one of a silicone-based additive, an amide-based additive, and a fatty acid-based surfactant.

5. A silicon substrate of a solar cell according to claims 2 to 4, wherein the solvent includes at least one of hexane, toluene, ethyl cellosolve, cyclohexanone, butyl cellosolve, butyl carbitol (diethylene glycol monobutyl ether), dibutyl carbitol (diethylene glycol dibutyl ether), butyl carbitol acetate (diethylene glycol monobutyl ether acetate), propylene glycol monomethyl ether, hexylene glycol, methylethylketone, benzylalcohol, γ-butyrolactone, ethyl lactate, texanol, and diethylene glycol dibutyl ether.

6. A silicon substrate of a solar cell according to claims 2 to 5, wherein the organic binder includes at least one of ethyl hydroxyethyl cellulose, nitrocellulose, blends of ethyl cellulose and phenol resins, alkyd resins, phenol resins, acrylate ester resins, xylene resins, polybutane resins, polyester resins, urea resins, melamine resins, vinyl acetate resins, wood rosin, polymethacrylates of alcohols, polyvinyl butyrate, and polyvinyl acetal.

7. A silicon substrate of a solar cell according to claims 1 to 6, wherein the composition for solar cell electrodes further includes at least one additive of a dispersant, a thixotropic agent, a plasticizer, a viscosity stabilizer, an anti-foaming agent, a pigment, a UV stabilizer, an antioxidant, and a coupling agent.

## Patentansprüche

1. Siliciumsubstrat einer Solarzelle, wobei das Siliciumsubstrat eine Zusammensetzung für Solarzellenelektroden umfasst, wobei das Siliciumsubstrat mit wenigstens 5 Erhebungen mit einer Querschnittshöhe (h) von 50 mm oder mehr pro 5 µm Länge gebildet ist, wobei die Zusammensetzung auf das Siliciumsubstrat aufgebracht ist, um die Elektrode zu bilden, und auf die mit den Erhebungen gebildete Fläche des Siliciumsubstrats abgeschieden ist, **dadurch gekennzeichnet, dass** die Zusammensetzung einen Wasserkontaktwinkel von 15° bis 60° aufweist, und wobei der Wasserkontaktwinkel der Zusammensetzung durch Auftropfen von destilliertem Wasser auf die Oberfläche eines Films der Zusammensetzung und Messen des Winkels zwischen der Tangente des Wassers und der Oberfläche des Films an deren Zusammentreffen gemessen wird.

2. Siliciumsubstrat einer Solarzelle gemäß Anspruch 1, wobei die Zusammensetzung für Solarzellenelektroden enthält: 60 Gew.-% bis 95 Gew.-% an einem leitfähigen Pulver; 0,1 Gew.-% bis 20 Gew.-% an einer Glasfritte; 0,1 Gew.-% bis 15 Gew.-% an einem anorganischen Bindemittel; 0,1 Gew.-% bis 5 Gew.-% an einem Oberflächenspannungsmodifikator; und 0,1 Gew.-% bis 20 Gew.-% an einem Lösungsmittel.

3. Siliciumsubstrat einer Solarzelle gemäß Anspruch 2, wobei die Glasfritte wenigstens ein elementares Metall von Tellur (Te), Lithium (Li), Zink (Zn), Bismut (Bi), Blei (Pb), Natrium (Na), Phosphor (P), Germanium (Ge), Gallium (Ga), Cer (Ce), Eisen (Fe), Silicium (Si), Wolfram (W), Magnesium (Mg), Molybdän (Mo), Cäsium (Cs), Strontium (Sr), Titan (Ti), Zinn (Sn), Indium (In), Vanadium (V), Barium (Ba), Nickel (Ni), Kupfer (Cu), Kalium (K), Arsen (As), Cobalt (Co), Zirkonium (Zr), Mangan (Mn), Aluminium (Al) und Bor (B) enthält.

4. Siliciumsubstrat einer Solarzelle gemäß Ansprüchen 2 oder 3, wobei der Oberflächenspannungsmodifikator wenigstens eines von einem Zusatzstoff auf Siliciumbasis, einem Zusatzstoff auf Amidbasis und einem Tensid auf Fettsäurebasis enthält.

5. Siliciumsubstrat einer Solarzelle gemäß Ansprüchen 2 bis 4, wobei das Lösungsmittel wenigstens eines von Hexan, Toluol, Ethyl-Cellosolve, Cyclohexanon, Butyl-Cellosolve, Butylcarbitol (Diethylenglycolmonobutylether), Dibutylcarbitol (Diethylenglycoldibutylether), Butylcarbitolacetat (Diethylenglycolmonobutyletheracetat), Propylenglycolmonomethylether, Hexylenglycol, Methylethylketon, Benzylalkohol, γ-Butyrolacton, Ethyllactat, Texanol und Diethylenglycoldibutylether enthält.

6. Siliciumsubstrat einer Solarzelle gemäß Ansprüchen 2 bis 5, wobei das organische Bindemittel wenigstens eines von Ethylhydroxyethylcellulose, Nitrocellulose, Gemischen von Ethylcellulose und Phenolharzen, Alkydharzen, Phenolharzen, Acrylatesterharzen, Xylenharzen, Polybutanharzen, Polyesterharzen, Harnstoffharzen, Melaminharzen, Vinylacetatharzen, Holzkolophonium, Polymethacrylaten von Alkoholen, Polyvinylbutyrat und Polyvinylacetal enthält.

7. Siliciumsubstrat einer Solarzelle gemäß Ansprüchen 1 bis 6, wobei die Zusammensetzung für Solarzellenelektroden ferner wenigstens einen Zusatzstoff von einem Dispergiermittel, einem thixotropen Mittel, einem Weichmacher, einem Viskositätsstabilisator, einem Antischaummittel, einem Pigment, einem UV-Stabilisator, einem Antioxidationsmittel und einem Kopplungsmittel enthält.

## Revendications

1. Substrat de silicium d'une cellule solaire, le substrat de silicium comprenant une composition pour des électrodes de cellules solaires, le substrat de silicium étant formé avec au moins 5 parties surélevées ayant une hauteur de section transversale (h) de 50 nm ou plus par 5 µm de longueur, la composition étant appliquée sur le substrat de silicium pour former l'électrode et étant déposée sur la surface du substrat de silicium formé avec les parties surélevées, **caractérisé en ce que** la composition possède un angle de contact avec l'eau de 15° à 60°, et l'angle de contact avec l'eau de la composition étant mesuré en faisant tomber de l'eau distillée sur la surface d'un film de la composition et en mesurant un angle entre la tangente de l'eau et la surface du film à leur jonction.

2. Substrat de silicium d'une cellule solaire selon la revendication 1, la composition pour des électrodes de cellules solaires comprenant : 60 % en poids à 95 % en poids d'une poudre conductrice ; 0,1 % en poids à 20 % en poids d'une fritte de verre ; 0,1 % en poids à 15 % en poids d'un liant organique ; 0,1 % en poids à 5 % en poids d'un modificateur de tension de surface ; et 0,1 % en poids à 20 % en poids d'un solvant.

3. Substrat de silicium d'une cellule solaire selon la revendication 2, la fritte de verre comprenant au moins un métal élémentaire parmi le tellure (Te), le lithium (Li), le zinc (Zn), le bismuth (Bi), le plomb (Pb), le sodium (Na), le phosphore (P), le germanium (Ge), le gallium (Ga), le cérium (Ce), le fer (Fe), le silicium (Si), le tungstène (W), le magnésium (Mg), le molybdène (Mo), le césium (Cs), le strontium (Sr), le titane (Ti), l'étain (Sn), l'indium (In), le vanadium (V), le baryum (Ba), le nickel (Ni), le cuivre (Cu), le potassium (K), l'arsenic (As), le cobalt (Co), le zirconium (Zr), le manganèse (Mn), l'aluminium (Al) et le bore (B).

4. Substrat de silicium d'une cellule solaire selon les revendications 2 ou 3, le modificateur de tension de surface comprenant au moins l'un parmi un additif à base de silicone, un additif à base d'amide et un tensioactif à base d'acide gras.

5. Substrat de silicium d'une cellule solaire selon les revendications 2 à 4, le solvant comprenant au moins l'un parmi l'hexane, le toluène, l'éthylcellosolve, la cyclohexanone, le butylcellosolve, le butylcarbitol (éther monobutylique de diéthylène glycol), le dibutylcarbitol (éther dibutylique de diéthylène glycol), l'acétate de butylcarbitol (acétate d'éther monobutylique de diéthylène glycol), l'éther monométhylique de propylène glycol, l'hexylèneglycol, la méthyléthylcétone, l'alcool benzylique, la γ-butyrolactone, le lactate d'éthyle, le texanol et l'éther dibutylique de diéthylène glycol.

6. Substrat de silicium d'une cellule solaire selon les revendications 2 à 5, le liant organique comprenant au moins l'un parmi une éthylhydroxyéthylcellulose, une nitrocellulose, des mélanges d'éthylcellulose et de résines phénoliques, des résines d'alkyde, des résines phénoliques, des résines d'ester d'acrylate, des résines de xylène, des résines de polybutane, des résines de polyester, des résines d'urée, des résines de mélamine, des résines d'acétate de vinyle, une rosine de bois, des polyméthacrylates d'alcools, un poly(butyrate de vinyle) et un polyvinylacétal.

7. Substrat de silicium d'une cellule solaire selon les revendications 1 à 6, la composition pour des électrodes de cellules solaires comprenant en outre au moins un additif parmi un dispersant, un agent thixotropique, un plastifiant, un stabilisant de viscosité, un agent antimousse, un pigment, un stabilisant UV, un antioxydant et un agent de couplage.
